# EUROPÄISCHE PATENTSCHRIFT

(11) **EP 0 632 578 B1**
(45) Veröffentlichungstag und Bekanntmachung des Hinweises auf die Patenterteilung: **01.08.2001**
(21) Anmeldenummer: 94108504.5
(22) Anmeldetag: 03.06.1994
(51) Int. Cl.: H03F 1/02, H03F 3/45, H03H 11/46

(54) **Elektronische Arbeitswiderstände**
Electronic load resistor
Résistance de charge électronique

(30) Priorität: 17.06.1993 DE 4320006
(43) Veröffentlichungstag der Anmeldung: 04.01.1995
(73) Patentinhaber: ATMEL Germany GmbH, 74072 Heilbronn (DE)
(72) Erfinder: Böhme, Rolf, Dr., D-74177 Bad Friedrichshall (DE)
(74) Vertreter: Maute, Hans-Jürgen, Dipl.-Ing.

(56) Entgegenhaltungen:
- EP-A- 0 296 131
- DE-A- 4 210 215
- FR-A- 2 277 461
- US-A- 5 119 041

## Beschreibung

Die Erfindung betrifft elektronische, von wenigstens einer Signalquelle gespeisten Arbeitswiderstände für leistungsarme, bipolare Schaltungen und für Regelverstärker und die Verwendung derselben zur Symmetrierung unsymmetrischer Signale.

In Verstärkerschaltungen werden Arbeitswiderstände gewöhnlich zur Umsetzung von Strom in Spannung verwendet, indem ein Verstärkerelement, z. B. ein bipolarer Transistor, einen Ausgangsstrom liefert, der einen Spannungsabfall über einem Arbeitswiderstand hervorruft, der dann als Eingangsspannung einer weiteren Verstärkerstufe verwendet werden kann. Eine Differenzstufe liefert zwei Ausgangsströme und benötigt normalerweise zwei Arbeitswiderstände. Es gibt auch Anordnungen mit mehr als zwei Ausgangsströmen. Auch für die Symmetrierung erdunsymmetrischer Signale werden meist Widerstände, eingebettet in eine Hilfsschaltung, verwendet. Wird dabei das Ziel kleiner Stromaufnahme verfolgt, so ergeben sich in bipolar integrierten Schaltungen große Arbeitswiderstände, die unverhältnismäßig viel Platz beanspruchen und durch ihre Sperrschichtkapazität den Frequenzgang nachteilig beeinflussen. Der erhöhte Platzbedarf führt auch zu entsprechend erhöhten Kosten für die Herstellung der integrierten Schaltung. Aus diesem Grunde wurde in Zusammenhang mit aktiven Filtern vorgeschlagen (EP 0296131), statt eines Widerstandes eine Reihenschaltung von Dioden zu verwenden. Es ist auch möglich, einen Widerstand elektronisch durch "bootstrapping" zu vergrößern (VLSI design techniques for analog and digital circuits, McGraw-Hill Book Co.Singapore 1990, S. 327).

Bei einer Reihenschaltung von Dioden ergibt sich jedoch ein erheblicher Spannungsbedarf, der hinsichtlich Leistungsbilanz und Aussteuerbarkeit sehr unerwünscht ist. Eine Widerstandsvergrößerung durch bootstrapping ist nicht sehr stabil und benötigt zusätzliche Koppelkondensatoren, im, Widerspruch zur angestrebten Flächenersparnis.

Auch die in DE 4210215 beschriebene Kaskodenschaltung hat den Nachteil, daß zur Umwandlung des Ausgangsstromes der Eingangstransistoren in eine Eingangsspannung für die nachfolgende Verstärkerstufe eine zusätzliche Referenzspannung an den Kaskodenstufen benötigt wird.

Die Aufgabe der Erfindung besteht deshalb darin, elektronische Arbeitswiderstände anzugeben, die anstelle passiver Widerstände einsetzbar sind, die einen geringen Strombedarf haben, deren Flächenbedarf in einer integrierten Schaltung gering ist und die nicht durch größere Sperrschichtkapazitäten belastet sind.

Zur Lösung dieser Aufgabe werden die ohmschen Arbeitswiderstände durch Lastelemente, die jeweils einen nichtlinearen Zweipol darstellen, gemäß den kennzeichnenden Merkmalen der Ansprüche 1 und 2 ersetzt. Hiernach bilden die gesteuerten Stromquellen mit den Lastelementen und dem Regelglied bzw. Regelgliedern einen Regelkreis zur Konstanthaltung des Potentials an den Lastelementen. Durch die Verwendung solcher Lastelemente kann der Stromverbrauch von Differenzstufen bis in die Größenordnung der Restströme abgesenkt werden, ohne daß der Flächenbedarf zunimmt. Der zusätzliche Strombedarf für die elektronischen Arbeitswiderstände beträgt lediglich das 1/V-fache des Strombedarfs einer speisenden Differenzstufe, wobei V die Verstärkung der Differenzstufe ist.

Als Lastelemente können in vorteilhafter Weise Halbleiterdioden bzw. als Dioden geschaltete Transistoren eingesetzt werden. Die Substratkapazität solcher Transistordioden ist klein gegenüber der von großen implantierten Widerständen, so daß sich der wirksame Frequenzbereich vergrößert. Die Nichtlinearität der Transistordioden entspricht völlig der Nichtlinearität einer nachfolgenden Differenzverstärkerstufe, wobei die Strom-Spannungs-Wandlung an den Transistordioden und die nachfolgende Spannungs-Strom-Wandlung in einer Differenzverstärkerstufe eine im Prinzip völlig verzerrungsfreie Verstärkung ergibt. Ein weiterer Vorteil besteht darin, daß Halbleiterdioden bei kleinen Strömen überwiegendes Schrotrauschen aufweisen, während Widerstände thermisch rauschen. Hierbei ist die Rauschleistung von Dioden mit einem differentiellen Widerstand Rx nur halb so groß wie die Rauschleistung eines ohmschen Widerstandes der Größe Rx, so daß sich auch von dieser Seite keine Verschlechterung der Eigenschaften ergibt.

Weitere vorteilhafte Ausgestaltungen der Erfindung ergeben sich aus den abhängigen Ansprüchen.

Im folgenden soll die Erfindung anhand von Ausführungsbeispielen im Zusammenhang mit den Zeichnungen dargestellt und erläutert werden. Es zeigen:
- Figur 1: eine Schaltungsanordnung mit drei Lastelementen, deren Frequenzbereich Gleichgrößen einschließt und die auch zur Symmetrierung unsymmetrischer Signalquellen verwendet werden kann,
- Figur 2: eine Schaltungsanordnung mit zwei Lastelementen für Signale oberhalb einer vorgesehenen Grenzfrequenz, die statisch unsymmetrische Signale ausgleichen kann,
- Figur 3: die Einfügung elektronischer Arbeitswiderstände zwischen zwei Differenzstufen,
- Figur 4: einige Beispiele für die Ausführung des Regelgliedes,
- Figur 5: ein Beispiel für den Übersteuerungsschutz mit Begrenzungsdioden oder Transistoren,
- Figur 6: ein Beispiel für den Übersteuerungsschutz durch Regelung der elektronischen Arbeitswiderstände,
- Figur 7: eine Schaltungsanordnung mit zusätzlichen Regelgliedern, die zur Arbeitspunktstabilisierung an einer vorausgehenden Funktionseinheit verwendet werden können und
- Figur 8: die Verwendung elektronischer Arbeitswiderstände zur Bias-Versorgung einer Differenzstufe mit Erzeugung eines wohldefinierten Eingangswiderstandes.

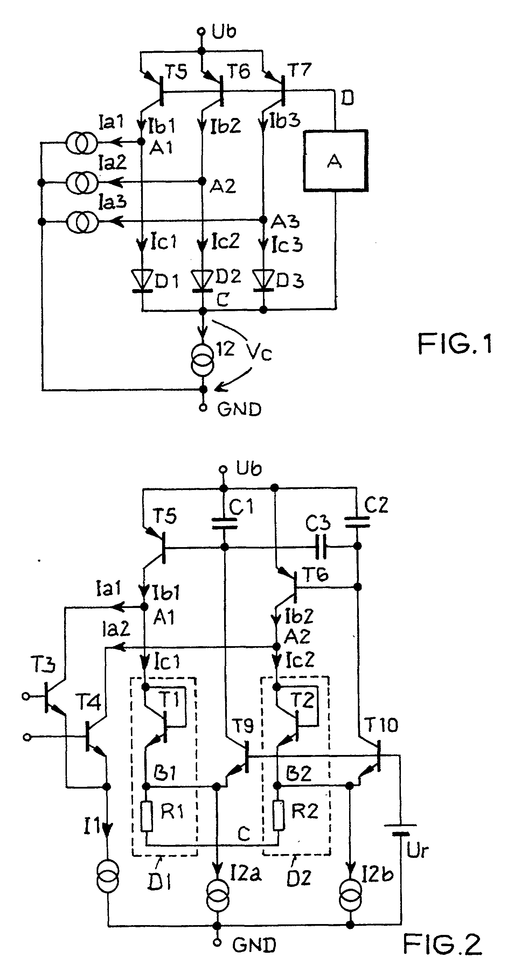

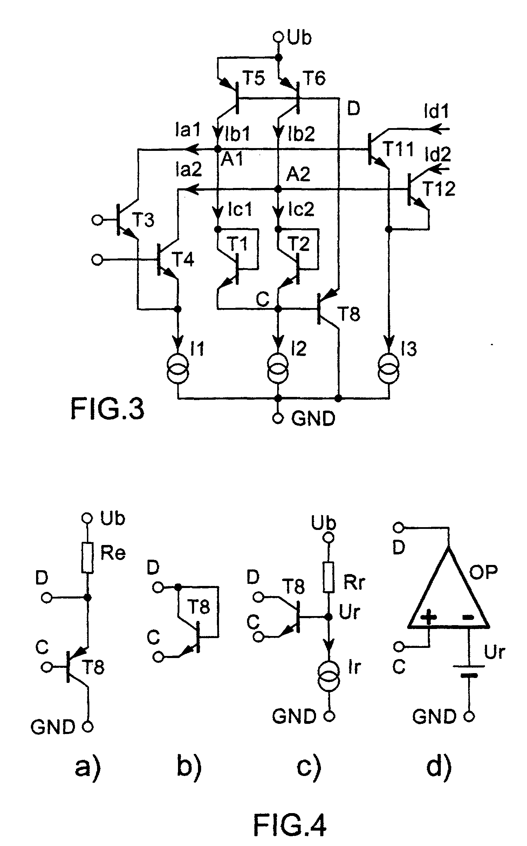

In Figur 1 stellen die Stromquellen Ia1, Ia2, Ia3 die Signalstromquellen dar, die im Sinne der Erfindung einen Ruhestrom überlagert mit einem Signalstrom liefern. Die Knoten A1, A2, A3 entsprechen den Anschlüssen von Arbeitswiderständen. Je ein Lastelement D1, D2 oder D3, das allgemein als nichtlinearer Zweipol aufzufassen ist, ist jeweils mit seinem ersten Anschluß an einen Knoten A1, A2 oder A3 angeschlossen. Die zweiten Anschlüsse der Lastelemente sind in einem Knoten C zusammengelegt. Eine Versorgungsstromquelle I2 versorgt die Lastelemente mit Strom (wobei I2 auch den Wert des Stromes bedeuten soll). Im vorliegenden Fall sind die Lastelemente D1, D2 und D3 als Dioden ausgebildet. Gleichzeitig ist ein Regelglied A an den Lastelementen, hier speziell am Knoten C, angeschlossen, das eine Verbindung zu den Eingängen D von steuerbaren Stromquellen T5, T6 und T7, die als npn-Transistoren ausgebildet sind, herstellt, deren Kollektoren ebenfalls jeweils mit den Knoten A1, A2 und A3 verbunden sind, während deren Emitter auf dem Potential der Betriebsspannung Ub liegen. Das Regelglied A hat im einfachsten Fall nur die Aufgabe, für geeignete Arbeitspotentiale der Knoten A1, A2 und A3 zu sorgen und kann aus einer einfachen Diode, Zenerdiode o. ä. bestehen. Für höherwertige Regelungen kann auch ein Transistor wie in Figur 4a) oder ein Differenzverstärker wie in Figur 4d) verwendet werden.

Der Versorgungsstrom I2 belastet den Knoten C und wirkt in Richtung auf eine Absenkung von dessen Spannung Vc (gegen Masse GND). Eine Absenkung von Vc wird über das Regelglied A an die Eingänge D der gesteuerten Stromquellen T5, T6, T7 weitergegeben, die daraufhin ihre Ströme Ib1, Ib2, Ib3 erhöhen. Dies wirkt der angenommenen Absenkung entgegen, so daß sich ein Gleichgewichtszustand ausbildet. Nimmt man an, daß das Regelglied A am Knoten C keinen wesentlichen Strom benötigt, so fließt der Versorgungsstrom I2 ausschließlich in die Lastelemente D1, D2, D3 und es gilt I2 = Ic1+Ic2+Ic3. Im Normalfall sind die gesteuerten Stromquellen T5, T6, T7 untereinander gleich und also ist auch Ib1 = Ib2 = Ib3 = Ib. Den Strom der Signalquellen Ia1, Ia2, Ia3 kann man als Summe aus Mittelwert und einer Abweichung darstellen Ia1 = Ia+ia1, Ia2 = Ia+ia2, Ia3 = Ia+ia3. Definiert man noch Ic = I2/3, so ergibt sich Ic1 = Ic-ia1, Ic2 = Ic-ia2, Ic3 = Ic-ia3. Das heißt, daß in den Lastelementen die gleichen Stromunterschiede wirksam werden wie in den Signalquellen, daß aber der Grundwert allein durch den Strom Ic = I2/3 vorgegeben ist. Wählt man Ic < Ia, so sind die Unterschiede in Relation zum Grundwert größer. Die Anhebung der relativen Unterschiede kann zur Verstärkung genutzt werden, wie in den weiteren Ausführungsbeispielen aufgezeigt wird.

Weil die Ströme in den Lastelementen nicht vom Grundwert Ia der Signalströme Ia1, Ia2, Ia3 abhängen, sondern nur von ihren Unterschieden, ergibt sich die Symmetrierwirkung der Anordnung. Eine Unsymmetrie bei zwei Signalquellen bedeutet, daß die Änderung der einen nicht genau entgegengesetzt der Änderung der zweiten ist. Bei drei und mehr Signalquellen wird man Unsymmetrie am einfachsten so verstehen, daß die Summe aller Änderungen ungleich Null ist. In diesem Sinne wirkt die Anordnung symmetrierend, weil die Summe der die Lastelemente durchfließenden Ströme stets I2 beträgt und demzufolge die Summe von Änderungen Null sein muß. Die Symmetrierwirkung gilt für die durch die Lastelemente fließenden Ströme. Durch die Ausführung des Regelgliedes A als hochverstärkenden Differenzverstärker nach Figur 4d), dessen zweiter Eingang mit einer Referenzspannung Ur verbunden ist, kann man erreichen, daß die Spannung am Knoten C sich praktisch nicht mehr ändert. Dann genügen auch die Spannungen an den Knoten A1, A2, A3 einer Art von Symmetrie.

Figur 3 zeigt die Verwendung elektronischer Arbeitswiderstände als Verbindung zwischen zwei Differenzstufen. Die erste Differenzstufe besteht aus den Transistoren T3 und T4 und der Versorgungsstromquelle I1. Sie entnehmen den Anschlüssen A1, A2 der elektronischen Lastwiderstände die Ausgangsströme Ia1 und Ia2. Die zweite Differenzstufe aus den Transistoren T11 und T12 und der Versorgungsstromquelle I3 ist mit ihrem Eingang an die Anschlüsse A1, A2 angelegt. Die Lastelemente D1, D2 sind Transistordioden T1, T2. Das Regelglied besteht aus dem Transistor T8, der als Emitterfolger geschaltet ist.

Vernachlässigt man die Basisströme, so gilt wie in der Beschreibung zu Figur 1 Ib1 = Ia1+Ic1 und Ib2 = Ia2+Ic2. Da die Ströme Ib1 = Ib2 untereinander gleich und wegen Ib1+Ib2 = I1+I2 konstant sein müssen, hat jede Änderung von Ia1 bzw. Ia2 eine gleich große, entgegengesetzte Änderung von Ic1 bzw. Ic2 zur Folge. Je kleiner der Strom I2 ist, desto größer wird der differentielle Widerstand der Transistordioden T1, T2 und damit die Spannungsverstärkung vom Eingang der ersten Differenzstufe zum Ausgang A1-A2. Für technologisch gleichartige Transistoren ergibt sich die Verstärkung zu V = = I1/I2, wenn die Basisströme vernachlässigt werden, bei Verstärkungen bis zu etwa 10 % der Stromverstärkung der verwendeten Transistoren ergeben sich dabei nur geringe Abweichungen.

Der Strom 12 wird gegenüber einer Differenzstufe, die mit ohmschen Widerständen arbeitet, zusätzlich gebraucht. Die Beziehung V = I1/I2 zeigt, daß der zusätzlich benötigte Strom einem Faktor 1/V entspricht, also bei üblichen Verstärkungen nicht ins Gewicht fällt.

Die logarithmische Abhängigkeit der Flußspannung einer Halbleiterdiode vom durchfließenden Strom hat zur Folge, daß die Spannungsdifferenz zwischen A1 und A2 bei größerer Aussteuerung verzerrt ist. Die exponentielle Charakteristik der Transistoren T11, T12 der zweiten Differenzstufe hebt diese Verzerrung wieder auf, so daß sich ein linearer Zusammenhang zwischen den Eingangsströmen Ia1-Ia2 und den Ausgangsströmen Id1-Id2 ergibt.

Die elektronischen Arbeitswiderstände kompensieren somit die Nichtlinearität der zweiten Differenzstufe. Dadurch ist bei elektronischen Arbeitswiderständen ein größerer Aussteuerbereich als bei ohmschen Arbeitswiderständen möglich.

Halbleiterdioden zeigen im Gebiet nicht zu großer Ströme überwiegendes Schrotrauschen. Dabei ergibt sich, daß die Rauschleistung einer in Durchlaßrichtung stromdurchflossenen Halbleiterdiode, die den differentiellen Widerstand Rx hat, gerade halb so stark wie die eines entsprechenden ohmschen Widerstandes der Größe Rx ist. Damit ist der Rauschbeitrag der Halbleiterdioden in elektronischen Arbeitswiderständen geringer als der Beitrag entsprechender ohmscher Arbeitswiderstände. Zwar wird dieser Vorteil durch das Rauschen der steuerbaren Stromquellen T5, T6 überdeckt, doch zeigt sich, daß deren Rauschbeitrag höchstens ähnlich groß wie der der ersten Differenzstufe mit T3, T4 ist und durch Einfügung von Emitterwiderständen vor die Emitter von T5 und T6 weiter gesenkt werden kann.

Figur 4 stellt einige Varianten des Regelgliedes dar, wie es zwischen dem Verbindungspunkt C der Lastelemente und dem Eingang D der steuerbaren Stromquellen eingefügt werden kann. Die Teilzeichnung a) wiederholt die Ausführung von Figur 3, fügt dem Emitterfolger aber noch einen Lastwiderstand Re hinzu, durch den die Regelgeschwindigkeit erhöht wird.

In der Teilzeichnung b) besteht das Regelglied einfach aus einer Diode. Diese Form genügt bei nicht zu hohen Verstärkungen, solange der für die Basen von T5 und T6 benötigte Strom klein gegenüber dem Strom I2 ist. Bei I1/I2 >> 1 (praktisch über etwa 5) fällt der Basisstrom der steuerbaren Stromquellen stärker ins Gewicht, man erhält dann näherungsweise V = I1/(I2-Ir), wobei Ir der Basisstrom von T5 und T6 ist. Die Funktion der Schaltung ist nur solange gewährleistet, solange I2 > Ir ist.

Um eine kleinstmögliche Versorgungsspannung zu erreichen, empfiehlt sich das Regelglied nach Figur 4c). Der Basis des Transistors T8 wird eine Referenzspannung Ur zugeführt, die etwa 0,3 V unter der Versorgungsspannung Ub liegt. Diese kann gemäß der Darstellung (auch für mehrere Regelglieder) mit Hilfe eines Widerstandes Rr und einer Stromquelle Ir erzeugt werden. Mit diesem Regelglied wird ein Differenzverstärker mit elektronischen Arbeitswiderständen und üblichen Transistorstromquellen ab etwa Ub = 1,2 V arbeitsfähig. Hinsichtlich der Belastung des Knotens C durch die Eingangsströme der gesteuerten Stromquellen T5, T6 und der Korrektur der Verstärkungsformel gilt das gleiche wie zur Diodenbeschaltung unter Figur 4b) gesagte.

Schließlich zeigt Figur 4d) eine allgemeinere Ausführung mit einem Differenzverstärker OP und einer Referenzspannung Ur. Bei hinreichend großer Verstärkung des Differenzverstärkers OP wird die Spannung am Knoten C gleich der Referenzspannung Ur, unabhängig von den Versorgungsströmen I1 und I2.

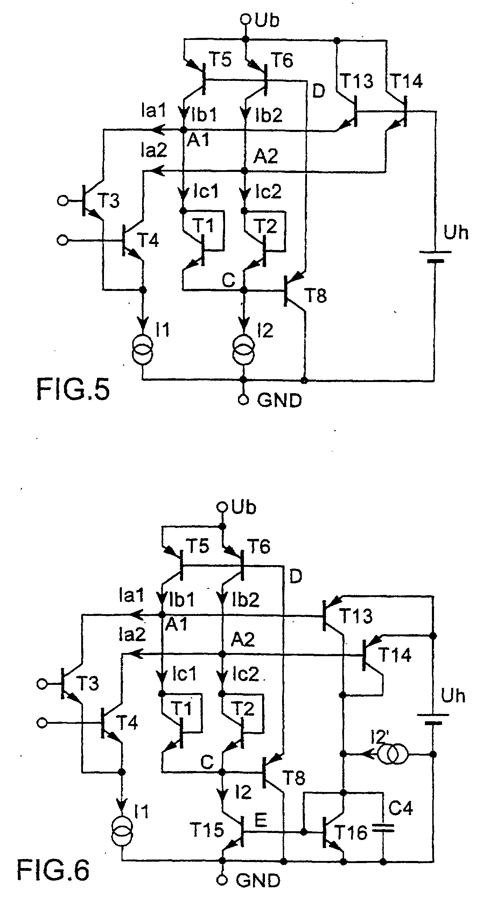

Wenn in einer Schaltung nach Figur 3 die Differenz der Ströme ¦Ia1-Ia2¦ > I2 wird, wird der Aussteuerbereich der elektronischen Arbeitswiderstände überschritten. Angenommen, es ist Ia1 > Ia2, so wird die Transistordiode T1 stromlos und die Spannung an A1 sinkt ab, bis die Basis-Kollektor-Diode von T3 leitend wird oder ein anderer Sättigungseffekt einsetzt. Um dies zu vermeiden, sind nach Figur 5 an den Klemmen A1, A2 Begrenzungstransistoren T13, T14 angeschlossen, die das unzulässige Absinken einer der Spannungen an A1 oder A2 verhindern. Die Basen der Begrenzungstransistoren werden je nach dem gewählten Arbeitspunkt an einer Hilfsspannung Uh angeschlossen, die Kollektoren an der Versorgungsspannung Ub. Gegebenenfalls können auch Kollektoren wie Basen an der Hilfsspannung Uh oder an der Versorgungsspannung Ub angeschlossen sein.

Wie aus der Beziehung V = I1/I2 hervorgeht, kann die Verstärkung V über das Stromverhältnis eingestellt werden. Dies führt auf die Möglichkeit, die Verstärkung dem Signal anzupassen und auf diese Weise eine Übersteuerung zu verhindern. Dazu zeigt Figur 6 ein Ausführungsbeispiel. Anstelle der Begrenzungsdioden ist je eine Basis-Emitter-Diode eines Überwachungstransistors T13, T14 angeordnet. Die Kollektoren sind an die Basis E eines Stromquellen-Transistors T15 angeschlossen, der eine Realisierung der Versorgungsstromquelle I2 darstellt. Die Arbeitspunkte der Überwachungstransistoren sind so gewählt, daß erst bei einer größeren Aussteuerung ein beachtenswerter Strom zum Eingang E entsteht. Dieser Strom verstärkt oder erzeugt den Strom im Transistor T15, wodurch die Verstärkung abgesenkt und einer Übersteuerung vorgebeugt wird. Durch einen Siebkondensator C4 zwischen Eingang E und Masse GND wird der Verstärkungsregelung eine meist erwünschte Trägheit gegeben. Durch eine dem Eingang vorgeschaltete Transistordiode mit dem Transistor T16 kann die Verstärkungssteuerung von Schwankungen der Stromverstärkung des Transistors T15 unabhängiger gemacht werden. Der Grundstrom I2 kann vor einer Übersteuerung, wie in der Zeichnung dargestellt, durch eine unabhängige Stromquelle I2', die den Stromquelleneingang E speist, festgelegt werden. Es ist aber auch möglich, den Arbeitspunkt der Überwachungstransistoren T13, T14 so zu wählen, daß sie bereits im Ruhezustand einen Strom führen, wie er zur Erzeugung von I2 erforderlich ist.

Beim Einsatz elektronischer Arbeitswiderstände für Wechselgrößen besteht der Wunsch, Drifteffekte und unerwünschte Gleichgrößen zu unterdrücken. Dies wird gemäß Figur 2 dadurch erreicht, daß die Lastelemente D1, D2 aus einer Reihenschaltung von jeweils zwei Schaltelementen T1, R1 und T2, R2 aufgebaut sind und je ein Regelglied T9, T10 an den Verbindungspunkten der Schaltelemente angeschlossen sind, wobei die Ausgänge der Regelglieder jeweils mit dem Eingang der zugeordneten, gesteuerten Stromquelle T5, T6 verbunden sind. An jedem Eingang einer gesteuerten Stromquelle ist ein Kondensator gegen eine Versorgungsklemme und/oder gegen einen anderen Eingang angeschlossen.

Das Funktionsprinzip dieser Schaltungserweiterung besteht darin, Gleich- und Wechselgrößen zu trennen und die Gleichgrößen in Gegenkopplung auf die Eingangsanschlüsse A1, A2 zurückzuführen. Um die Gleichgrößen in geeigneter Polarität zu gewinnen, sind die Lastelemente D1, D2 im Ausführungsbeispiel durch die Reihenschaltung von Transistordiode T1 bzw. T2 und ohmschen Widerstand R1 bzw. R2 ausgeführt (in einer BICMOS-Technologie kann der Widerstand R1 bzw. R2 beispielsweise auch ein Feldeffekt-Bauelement sein). An den untereinander gleich angenommenen Widerständen R1, R2 entstehen Spannungsabfälle entsprechend den in den Lastelementen fließenden Strömen Ib1 bzw. Ib2. Sind die Ströme ungleich, entsteht eine Spannungsdifferenz zwischen den Verbindungspunkten. Die Regelglieder, die im Ausführungsbeispiel durch Transistoren T9, T10 in Basisschaltung ausgeführt sind, führen durch diese Spannungsdifferenz ungleiche Ströme. Entsprechend der Stromverstärkung der Transistoren T5, T6 der gesteuerten Stromquellen entstehen daraus ungleiche Ströme Ib1, Ib2. Diese Ungleichheit wirkt einer statischen Differenz der Eingangsströme Ia1, Ia2 entgegen; der statische Unterschied der Ströme Ib1 und Ib2 in den Lastelementen D1, D2 wird vermindert. Für die vorgesehene Funktion genügt normalerweise eine Größe der Widerstände R1, R2 im Bereich von 5 bis 20 % des differentiellen Widerstandes der Transistordioden T1, T2. Damit ist der Vorteil elektronischer Arbeitswiderstände gegenüber rein ohmschen Arbeitswiderständen zwar beeinträchtigt, aber nicht aufgehoben. Die Kompensation von Verzerrungen in einer nachfolgenden Differenzstufe wird ebenfalls beeinträchtigt, kann aber durch Einfügung entsprechend gewählter Emitterwiderstände wieder verbessert werden.

Die an den Eingängen der gesteuerten Quellen angeschlossenen Kapazitäten sorgen dafür, daß oberhalb einer Grenzfrequenz diese Gegenkopplung verschwindet. Durch die hohen Impedanzen an dieser Stelle genügen verhältnismäßig kleine Kapazitäten. Der Anwendung einer Kapazität C3 zwischen zwei Eingängen ist der Vorzug gegenüber zwei Kapazitäten C1, C2 gegen Ub oder GND zu geben, weil gleicher Effekt mit C3 = (C1+C2)/4 erreicht wird und weil der Frequenzbereich der Symmetrierwirkung (d. h. die Reaktion auf Gleichtaktkomponenten der Eingangsströme) weniger beeinträchtigt wird. Die kapazitive Beschaltung der Eingänge der gesteuerten Stromquellen erfüllt außerdem die Aufgabe, eine Beeinträchtigung der Stromquellenfunktion der Transistoren T5, T6 durch die Kollektor-Basis-Kapazität (Miller-Effekt) zu unterdrücken.

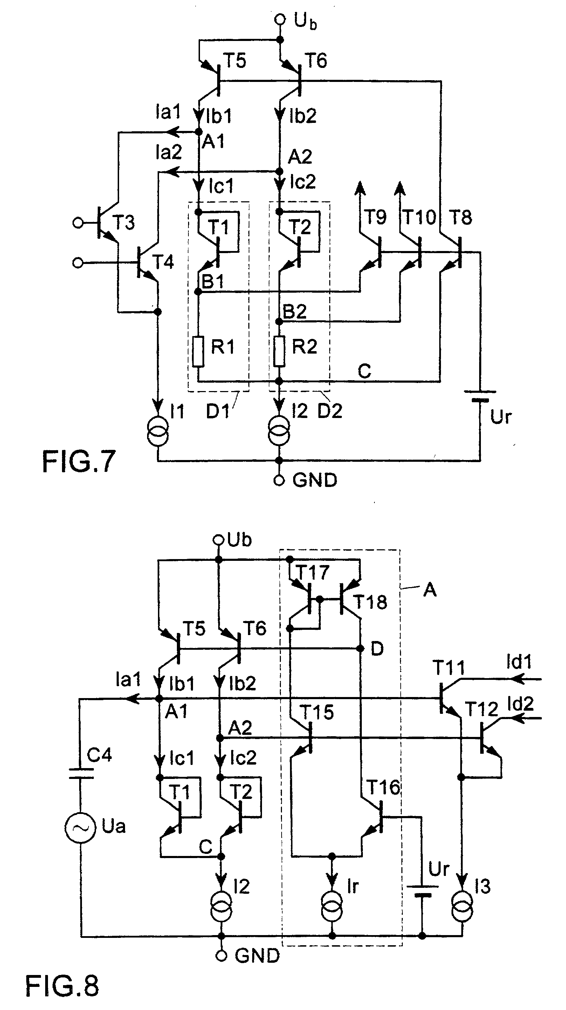

In mehrstufigen Wechselspannungsverstärkern ist es üblich, die Arbeitspunktstabilisierung als frequenzbegrenzte Gegenkopplung auszuführen. Ein geeignetes Ausgangssignal kann mit dem in Figur 7 dargestellten Ausführungsbeispiel erzeugt werden. Die Schaltung beinhaltet eine interne Arbeitspunktstabilisierung mit dem Regeltransistor T8, der am Verbindungspunkt C der Lastelemente D1, D2 angeschlossen ist und der kollektorseitig die Transistorstromquellen T5, T6 steuert. Die Lastelemente selbst sind als Reihenschaltung von Transistordiode T1 bzw. T2 und Widerstand R1 bzw. R2 ausgebildet. An den Verbindungspunkten dieser Reihenschaltungen sind weitere Regelglieder T9, T10 angeschlossen, deren Ausgangssignal zur Rückführung auf den Verstärkereingang vorgesehen ist. Die nähere Ausführung einer solchen Rückführung schließt die Begrenzung des übertragenen Frequenzbandes ein und erfolgt ansonsten mit schaltungstechnisch bekannten Mitteln.

Schließlich zeigt Figur 8 ein Beispiel, wie elektronische Arbeitswiderstände zur Bias-Versorgung einer Differenzstufe und Erzeugung eines wohldefinierten Eingangswiderstandes verwendet werden können. Die Differenzstufe T11, T12, I3 ist eingangsseitig mit den Anschlüssen A1, A2 der elektronischen Arbeitswiderstände verbunden. Das Regelglied A ist als Differenzverstärker mit Transistoren T15 bis T18 und Stromquelle Ir ausgeführt. Die Eingänge sind mit dem Anschluß A2 des elektronischen Arbeitswiderstandes und einer Referenzspannung Ur verbunden. Eine Signalquelle Ua (es kann auch eine Quelle mit Stromquellencharakter sein) ist, ggf. über einen Koppelkondensator C4, mit dem Anschluß A1 des elektronischen Arbeitswiderstandes und einem Eingang der Differenzstufe T11, T12 verbunden.

Der Regelverstärker A ist ein der Aufgabe angepaßter, hochverstärkender Differenzverstärker. Seine Eingangsspannung Ua2-Ur, wobei Ua1, Ua2 die Spannung am Anschluß A1 bzw. A2 bedeutet, ist deshalb klein im Verhältnis zu den übrigen Signalspannungen. In idealisierter Betrachtung wird der Anschluß A2 auf Referenzspannung Ur festgehalten. Eine Eingangsspannung Ua wird über C4 auf den Anschluß A1 übertragen, so daß die Spannungsdifferenz Ua1-Ua2 = Ua sein wird. Die Eingangsspannung wird somit an die Reihenschaltung der Transistordioden T1, T2 angelegt. Deren differentieller Widerstand ergibt sich mit der aus der Halbleiterphysik bekannten Temperaturspannung Ut = 25 mV (bei Zimmertemperatur) und dem durchfließenden Strom von je I2/2 zu 4Ut/I2. Der Eingangswiderstand hängt demnach außer von der Temperatur nur vom Strom I2 ab und kann somit durch 12 eingestellt werden. Der Eingangswiderstand der Differenzstufe T11/T12 ist dem elektronisch erzeugten Widerstand 4Ut/I2 parallel geschaltet und muß ggf. berücksichtigt werden. Die Biasströme der Differenzstufe werden durch den Regelmechanismus von den gesteuerten Stromquellen T5, T6 mit aufgebracht.

Wird der erste Eingang des Regelgliedes A statt am Anschluß A2 am Verbindungspunkt C angebracht, so wird die Spannung an C an die Referenzspannung Ur gebunden. Dann ergibt sich der elektronische Eingangswiderstand zu 2Ut/I2 und die Spannung am Anschluß A2 verändert sich im Gegentakt zur zugeführten Spannung an A1. Die elektronischen Arbeitswiderstände nehmen dabei die bereits beschriebene Symmetrierfunktion an.

Die in den Figuren 1 bis 8 dargestellten Ausführungsbeispiele können auch mit Transistoren vom entgegengesetzten Typ, also statt mit npn-Transistoren auch mit pnp-Transistoren und umgekehrt, aufgebaut werden. Ferner können statt Bipolartransistoren auch Feldeffekttransistoren eingesetzt werden.

## Patentansprüche

1. Elektronische Arbeitswiderstände, die von wenigstens einer Signalquelle (Ia1, Ia2, Ia3) gespeist werden, gekennzeichnet durch folgende Merkmale:
a) Es sind wenigstens zwei Lastelemente (D1, D2, D3), die jeweils einen nichtlinearen Zweipol darstellen, vorhanden, wobei der erste Anschluß (A1, A2, A3) eines Lastelementes mit der Signalquelle (Ia1, Ia2, Ia3) verbunden ist,
b ) der erste Anschluß (A1, A2, A3) der Lastelemente (D1, D2, D3) ist mit je einer steuerbaren Stromquelle (T5, T6, T7) verbunden,
c) die zweiten Anschlüsse (C) der Lastelemente (D1, D2, D3) sind direkt miteinander verbunden,
d) es ist wenigstens eine Versorgungsstromquelle (12) vorgesehen, die an den Verbindungspunkt der zweiten Anschlüsse der Lastelemente (D1, D2, D3) angeschlossen ist, und
e) an einen der Anschlüsse der Lastelemente (D1, D2, D3) ist ein Regelglied (A), das die steuerbaren Stromquellen (T5, T6, T7) steuert, angeschlossen.

2. Elektronische Arbeitswiderstände, die von wenigstens einer Signalquelle (Ia1, Ia2) gespeist werden, gekennzeichnet durch folgende Merkmale:
a) Es sind wenigstens zwei Lastelemente (D1, D2), die jeweils einen nichtlinearen Zweipol darstellen, vorhanden, die aus jeweils einer Reihenschaltung von zwei Schaltelementen (T1 , R1 ; T2, R2) bestehen, wobei der erste Anschluß (A1, A2) eines Lastelementes (D1, D2) mit der Signalquelle (Ia1, Ia2) verbunden ist,
b) der erste Anschluß (A1, A2) der Lastelemente (D1, D2) ist mit je einer steuerbaren, dem Lastelement (D1, D2) zugeordneten Stromquelle (T5, T6) verbunden,
c) die zweiten Anschlüsse (C) der Lastelemente (D1, D2) sind direkt miteinander verbunden,
d) die Verbindungspunkte (B1, B2) der beiden Schaltelemente (T1, R1; T2, R2) der Lastelemente (D1, D2) werden von je einer Versorgungsstromquelle (12a, 12b) gespeist,
e) der jeweilige Verbindungspunkt (B1, B2) der beiden Schaltelemente (T1, R1, T2, R2) eines Lastelementes (D1, D2) ist mit dem Eingang der zugeordneten steuerbaren Stromquelle über je ein Regelglied (T9, T10) verbunden und
f) jeder Eingang der gesteuerten Stromquellen (T5, T6) ist mit einer Kapazität (C1, C2, C3) gegen einen Referenzpunkt und/oder gegen einen anderen Eingang geschaltet.

3. , Elektronische Arbeitswiderstände nach Anspruch 1, dadurch gekennzeichnet, daß ein Lastelement (D1, D2, D3) aus einer Reihenschaltung von zwei Schaltelementen (T1, R1; T2, R2) besteht.

4. Elektronische Arbeitswiderstände nach einem der Ansprüche 1 bis 3, dadurch gekennzeichnet, daß das Lastelement (D1 D2, D3) bzw. das Schaltelement (T1, T2) eine Halbleiterdiode oder eine Transistordiode ist.

5. Elektronische Arbeitswiderstände nach Anspruch 4, dadurch gekennzeichnet, daß das andere Schaltelement ein ohmscher Widerstand (R1, R2) ist.

6. Elektronische Arbeitswiderstände nach einem der Ansprüche 1, 3 bis 5, dadurch gekennzeichnet, daß das Regelglied (A) an dem Verbindungspunkt (C) der zweiten Anschlüsse der Lastelemente (D1, D2, D3) angeschlossen ist.

7. Elektronische Arbeitswiderstände nach einem der Ansprüche 1, 3 bis 5, dadurch gekennzeichnet, daß das Regelglied an einem ersten Anschluß (A1, A2) eines Lastelementes (D1, D2) angeschlossen ist.

8. Elektronische Arbeitswiderstände nach einem der vorangehenden Ansprüche, dadurch gekennzeichnet, daß das Regelglied aus einer Diode besteht.

9. Elektronische Arbeitswiderstände nach einem der Ansprüche 1 bis 7, dadurch gekennzeichnet, daß das Regelglied aus einem Differenzverstärker besteht, dessen zweitem Eingang eine Referenzspannung zugeführt wird.

10. Elektronische Arbeitswiderstände nach einem der Ansprüche 1 bis 7, dadurch gekennzeichnet, daß das Regelglied aus einem bipolaren Transistor besteht, wobei als Steuereingang der Emitteranschluß, als Referenzeingang der Basisanschluß und als Ausgang der Kollektoranschluß dient.

11. Elektronische Arbeitswiderstände nach einem der vorangehenden Ansprüche, dadurch gekennzeichnet, daß die gesteuerten Stromquellen als Transistorstromquellen aufgebaut sind.

12. Elektronische Arbeitswiderstände nach einem der vorangehenden Ansprüche, dadurch gekennzeichnet, daß die Versorgungsstromquellen als Transistorstromquellen aufgebaut sind, die an der Basis gesteuert werden können.

13. Elektronische Arbeitswiderstände nach einem der vorangehenden Ansprüche, dadurch gekennzeichnet, daß der erste Anschluß eines Lastelementes mit dem Emitteranschluß eines Begrenzungstransistors (T13, T14) oder mit dem einen Anschluß einer Begrenzungsdiode verbunden ist.

14. Elektronische Arbeitswiderstände nach Anspruch 13 dadurch gekennzeichnet, daß der Kollektoranschluß des Begrenzungstransistors oder der zweite Anschluß der Begrenzungsdiode mit einem Pol der Versorgungsspannung (U_{b}) verbunden ist.

15. Elektronische Arbeitswiderstände nach Anspruch 13 dadurch gekennzeichnet, daß die Basis des Begrenzungstransistors oder der zweite Anschluß der Begrenzungsdiode mit einer Hilfsspannung (-Uₕ) verbunden ist.

16. Elektronische Arbeitswiderstände nach einem der Ansprüche 13 bis 15, dadurch gekennzeichnet, daß die Begrenzungsdiode die Emitter-Basis-Diode eines bipolaren Transistors ist und der Kollektor dieses Transistors die Versorgungsstromquelle(n) steuert.

17. Elektronische Arbeitswiderstände nach Anspruch 16, dadurch gekennzeichnet, daß dem Steuereingang der Versorgungsstromquelle(n) (12, T15) eine Transistordiode (T16) parallel geschaltet ist.

18. Elektronische Arbeitswiderstände nach Anspruch 16 oder 17, dadurch gekennzeichnet, daß dem Steuereingang der Versorgungsstromquelle(n) ein Kondensaton (C4) parallel geschaltet ist.

## Claims

1. Electronic load resistors which are fed from at least one signal source (Ia1, Ia2, Ia3) and which are characterised by the following features;
a) there are provided at least two load elements (D1, D2, D3) which each represent a non-linear two pole device, whereby the first terminal (A1, A2, A3) of a load element is connected to the signal source (Ia1, Ia2, Ia3),
b) the first terminal (A1, A2, A3) of the load element (D1, D2, D3) is connected to a respective controllable current source (T5, T6, T7),
c) the second terminals (C ) of the load elements (D1, D2, D3) are connected directly to one another,
d) there is provided at least one current supply source (12) which is connected to the connecting point of the second terminals of the load elements (D1, D2, D3), and
e) a regulating member (A), which controls the controllable current sources (T5, T6, T7), is connected to one of the terminals of the load elements (D1, D2, D3).

2. Electronic load resistors which are fed from at least one signal source (Ia1, Ia2) and which are characterised by the following features;
a) there are provided at least two load elements (D1, D2) which each represent a non-linear two pole device that comprises a series circuit consisting of two circuit elements (T1, R1; T2, R2), whereby the first terminal (A1, A2) of a load element (D1, D2) is connected to the signal source (Ia1, Ia2),
b) the first terminal (A1, A2) of the load element (D1, D2) is connected to a respective controllable current source (T5, T6) which is associated with the load element (D1, D2),
c) the second terminals (C ) of the load elements (D1, D2) are connected directly to one another,
d) the connecting points (B1, B2) of the two circuit elements (T1, R1; T2, R2) of the load elements (D1, D2) are fed by a respective current supply source (I2a, I2b),
e) the connecting point (B1, B2) of the two circuit elements (T1, R1; T2, R2) of a load element (D1, D2) is connected via a respective regulating member (T9, T10) to the input of the controllable current source associated therewith, and
f) each input of the controlled current sources (T5, T6) is connected to a capacitor (C1, C2, C3) whose other terminal is connected to a reference point and/or to another input.

3. Electronic load resistors in accordance with Claim 1, characterised in that a load element (D1, D2, D3) consists of a series circuit comprising two circuit elements (T1, R1; T2, R2).

4. Electronic load resistors in accordance with any of Claims 1 to 3, characterised in that the load element (D1, D2, D3) or the circuit element (T1, T2) is a semiconductor diode or a transistor diode.

5. Electronic load resistors in accordance with Claim 4, characterised in that the other circuit element is an ohmic resistor (R1, R2).

6. Electronic load resistors in accordance with any of Claims 1, 3 to 5, characterised in that the regulating member (A) is connected to the connecting point (C) of the second terminals of the load elements (D1, D2, D3).

7. Electronic load resistors in accordance with any of Claims 1, 3 to 5, characterised in that the regulating member is connected to a first terminal (A1, A2) of a load element (D1, D2).

8. Electronic load resistors in accordance with any of the preceding Claims, characterised in that the regulating member consists of a diode.

9. Electronic load resistors in accordance with any of Claims 1 to 7, characterised in that the regulating member consists of a differential amplifier, to the second input of which, a reference voltage is supplied.

10. Electronic load resistors in accordance with any of Claims 1 to 7, characterised in that the regulating member consists of a bipolar transistor, whereby the emitter terminal thereof serves as a control input, the base terminal thereof as a reference input and the collector terminal thereof as an output.

11. Electronic load resistors in accordance with any of the preceding Claims, characterised in that the controlled current sources are in the form of transistor current sources.

12. Electronic load resistors in accordance with any of the preceding Claims, characterised in that the current supply sources are in the form of transistor current sources which can be controlled at their base.

13. Electronic load resistors in accordance with any of the preceding Claims, characterised in that the first terminal of a load element is connected to the emitter terminal of a limiting transistor (T13, T14) or to the one terminal of a limiting diode.

14. Electronic load resistors in accordance with Claim 13, characterised in that the collector terminal of the limiting transistor or the second terminal of the limiting diode is connected to one pole of the supply voltage source (Ub).

15. Electronic load resistors in accordance with Claim 13, characterised in that the base of the limiting transistor or the second terminal of the limiting diode is connected to an auxiliary voltage (Uh).

16. Electronic load resistors in accordance with any of Claims 13 to 15, characterised in that the limiting diode is the emitter-base diode of a bipolar transistor and the collector of this transistor controls the current supply source(s).

17. Electronic load resistors in accordance with Claim 16, characterised in that a transistor diode (T16) is connected in parallel with the control input of the current supply source(s) (I2; T15).

18. Electronic load resistors in accordance with Claim 16 or 17, characterised in that a capacitor (C4) is connected in parallel with the control input of the current supply source(s).

## Revendications

1. Résistances électroniques de travail, qui sont alimentées par au moins une source de signaux (Ia1, Ia2, Ia3), caractérisées par les caractéristiques suivantes :
a) il est prévu au moins deux éléments de charge (D1, D2, D3), qui représentent respectivement un dipôle non linéaire, la première borne (A1,A2,A3) d'un élément de charge étant reliée à la source de signaux (Ia1, Ia2, Ia3),
b) la première borne (A1,A2,A3) des éléments de charge (D1,D2,D3) est reliée à une source de courant commandable respective (T5, T6, T7),
c) les secondes bornes (C) des éléments de charge (D1,D2, D3) sont reliées entre elles directement,
d) il est prévu au moins une source d'alimentation en courant (I2), qui est raccordée au point de jonction des deux bornes des éléments de charge (D1,D2,D3), et
e) un circuit de régulation (A), qui commande les sources de courant commandables (T5,T6,T7), est raccordé à l'une des bornes des éléments de charge (D1,D2,D3).

2. Résistances électroniques de travail, qui sont alimentées par au moins une source de signaux (Ia1, Ia2), caractérisées par les caractéristiques suivantes :
a) il est prévu au moins deux éléments de charge (D1,D2), qui représentent respectivement un dipôle non linéaire et qui sont constitués respectivement par un circuit série de deux éléments de commutation (T1,R1; T2,R2), la première borne (A1,A2) d'un élément de charge (D1,D2) étant reliée à la source de signaux (Ia1,Ia2),
b) la première borne (A1,A2) des éléments de charge (D1,D2) est reliée à une source de courant commandable respective (T5,T6), associée à l'élément de charge (D1,D2),
c) les secondes bornes (C) des éléments de charge (D1,D2) sont reliées entre elles directement,
d) les points de liaison (B1,B2) des deux éléments de commutation (T1,R1; T2,R2) des éléments de charge (D1,D2) sont alimentés par une source respective de courant d'alimentation (I2a,I2b),
e) le point de liaison respectif (B1,B2) des deux éléments de commutation (T1,R1,T2,R2) d'un élément de charge (D1,D2) est relié à l'entrée de la source de courant commandable associée, par l'intermédiaire d'un circuit de régulation respectif (T9,T10),
f) chaque entrée des sources de courant commandées (T5, T6) est connectée à une capacité (C1,C2,C3) par rapport à un point de référence et/ou par rapport à une autre entrée.

3. Résistances électroniques de travail selon la revendication 1, caractérisées en ce qu'un élément de charge (D1,D2,D3) est constitué par un circuit série formé de deux éléments de commutation (T1,R1; T2,R2).

4. Résistances électroniques de travail selon l'une des revendications 1 à 3, caractérisées en ce que l'élément de charge (D1,D2,D3) ou l'élément de commutation (T1,T2) est une diode semiconductrice ou une diode de transistor.

5. Résistances électroniques de travail selon la revendication 4, caractérisées en ce que l'autre élément de commutation est une résistance ohmique (R1,R2).

6. Résistances électroniques de travail selon l'une des revendications 1, 3 à 5, caractérisées en ce que le circuit de régulation (A) est raccordé au point de liaison (C) des secondes bornes des éléments de charge (D1,D2,D3).

7. Résistances électroniques de travail selon l'une des revendications 1, 3 à 5, caractérisées en ce que le circuit de régulation est raccordé à une première borne (A1,A2) d'un élément de charge (D1,D2).

8. Résistances électroniques de travail selon l'une des revendications précédentes, caractérisées en ce que le circuit de régulation est constitué par une diode.

9. Résistances électroniques de travail selon l'une des revendications 1 à 7, caractérisées en ce que le circuit de régulation est constitué par un amplificateur différentiel, à la seconde entrée duquel est envoyée une tension de référence.

10. Résistances électroniques de travail selon l'une des revendications 1 à 7, caractérisées en ce que le circuit de régulation est constitué par un transistor bipolaire, auquel cas on utilise la borne d'émetteur comme entrée de commande, la borne de base comme entrée de référence et la borne de collecteur en tant que sortie.

11. Résistances électroniques de travail selon l'une des revendications précédentes, caractérisées en ce que les sources de courant commandées sont agencées sous la forme de sources de courant à transistors.

12. Résistances électroniques de travail selon l'une des revendications précédentes, caractérisées en ce que les sources de courant d'alimentation sont agencées sous la forme de sources de courant à transistors, qui peuvent être commandées au niveau de leur base.

13. Résistances électroniques de travail selon l'une des revendications précédentes, caractérisées en ce que la première borne d'un élément de charge est reliée à la borne d'émetteur d'un transistor de limitation (T13, T14) ou à une borne d'une diode de limitation.

14. Résistances électroniques de travail selon la revendication 13, caractérisées en ce que la borne de connecteur du transistor de limitation ou la seconde borne de la diode de limitation est reliée à un pôle de la tension d'alimentation (V_{b}).

15. Résistances électroniques de travail selon la revendication 13, caractérisées en ce que la base du transistor de limitation ou la seconde borne de la diode de limitation est reliée à une tension auxiliaire (-Uₕ).

16. Résistances électroniques de travail selon l'une des revendications 13 à 15, caractérisées en ce que la diode de limitation est la diode émetteur-base d'un transistor bipolaire et que le collecteur de ce transistor commande la ou les sources de courant d'alimentation.

17. Résistances électroniques de travail selon la revendication 16, caractérisées en ce qu'une diode de transistor (T16) est branchée en parallèle avec l'entrée de commande de la ou des sources de courant d'alimentation (12,T15).

18. Résistances électroniques de travail selon la revendication 16 ou 17, caractérisées en ce qu'un condensateur (C4) est branché en parallèle avec l'entrée de commande de la ou des sources de courant d'alimentation.
